Europäisches Patentamt

European Patent Office

Office européen des brevets

(11) Publication number: **0 263 312**
**A2**

## EUROPEAN PATENT APPLICATION

(21) Application number: 87113138.9

(22) Date of filing: 08.09.87

(51) Int. Cl.4 **G11C 29/00**

The title of the invention has been amended (Guidelines for Examination in the EPO, A-III, 7.3).

(30) Priority: 08.09.86 JP 210996/86
08.09.86 JP 210997/86

(43) Date of publication of application:
**13.04.88 Bulletin 88/15**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Furuyama, Tohru c/o Patent Division**
**Kabushiki Kaisha Toshiba 1-1 Shibaura**
**1-chome**
**Minato-ku Tokyo 105(JP)**
Inventor: **Natori, Kenji c/o Patent Division**
**Kabushiki Kaisha Toshiba 1-1 Shibaura**
**1-chome**
**Minato-ku Tokyo 105(JP)**

(74) Representative: **Henkel, Feiler, Hänzel &**
**Partner**
**Möhlstrasse 37**
**D-8000 München 80(DE)**

(54) Semiconductor memory device with a self-testing function.

(57) A semiconductor memory device comprises a self-test circuit (17, 18, 19, 20). The self-test circuit starts to operate in response to a control signal. The self-test circuit controls the operation of data writing and data reading so that data are written into the memory cells in the memory cell array and read out the data from the memory cells. The self-test circuit checks whether or not an error is contained in the read data by comparing the read data with the write data.

FIG. 1

## Semiconductor memory device

This invention relates to a semiconductor memory device of large memory capacity and, more particularly, to a semiconductor memory device with a self-test function to automatically check as to if defective cells are contained in a memory cell array.

Before starting up the operation, a system using semiconductors memory checks if defective memory cells are contained in the semiconductor memories. In this check, the memory cells are selected one by one, data is written into the selected cell. and it is checked whether or not the written data is properly read out. With increase of the memory capacity of a system including a plurality of semiconductor memories. much time is required to check presence or absence of defective memory cells. This causes a slow start-up of the system. The much check time deteriorates the system operation efficiency. Further, before starting up the system, such waiting time is essential for operators, and reduces the operability of the system. This is more remarkable when the maintenance of the system is more frequently done.

As described above, the system using the conventional memory devices needs much check time prior to the start-up of the system, and hence the system start-up is slow.

Accordingly, an object of this invention is to provide a semiconductor memory device which can automatically check whether or not defective cells are contained in the memories assembled into a system, and enables the system to quickly start up, with the remarkable reduction of the check time.

According to one aspect of this invention, there is provided a semiconductor memory device comprising a memory cell array including a plurality of memory cells, memory cell select means for selecting a memory cell in the memory cell array. data write means for writing data into the memory cell selected by the memory cell select means, data read out means for reading out the data from the memory cell selected by the memory cell select means, and self-test means for operating the data write and read means in responsive to a control signal, writing predetermined data into the memory cells in the memory cell array, reading out the data from the memory cells, and checking if an error is contained in the read out data.

In another aspect of this invention, the semiconductor memory device with the above-mentioned arrangement further comprises operation control means for detecting that predetermined signals are input to a plurality of terminals used in the normal operation in a predetermined order and predetermined levels, and for providing the control signal for operating the self-test means.

In the memory device according to this invention, self-test means is first driven by an external control signal. Following this, predetermined data are written into the memory cells in the memory cell array, by the data read/write control means. Then, the data are read out. It is checked if error data is present or absent. If error data is found. the error data detection is output to exterior.

In the memory device according to this invention the operation control means checks whether or not predetermined external signals are input in a predetermined order and levels. In response to the result of this check, the self-test means is operated. Following this. predetermined data are written into the memory cells in the memory cell array, by the data read/write control means. Then, the data are read out. It is checked if error data is present or absent. If error data is found, the error data detection is output to exterior.

This invention can be more fully understood from the following detailed description when taken in conjunction with the accompanying drawings, in which:

Fig. 1 shows a block diagram of a semiconductor memory device according to an embodiment of this invention;

Fig. 2 is a circuit diagram of a circuitry including an address counter and a write data generation circuit used in the semiconductor memory device of Fig. 1;

Fig. 3 shows a circuit diagram of a part of an address buffer/multiplexer used in the Fig. 1 circuit;

Fig. 4 shows a circuit diagram of a failure detection·failure signal generation circuit of the Fig. 1 circuit;

Fig. 5 shows a circuit diagram of a circuit for writing the data for checker board pattern;

Fig. 6 shows a block diagram of a semiconductor memory device according to another embodiment of this invention;

Fig. 7 shows a timing charts useful in explaining the operation of the Fig. 6 memory device;

Fig. 8 shows another example of timing charts of the operation of the Fig. 6 memory device; and

Fig. 9 shows a further example of timing charts of the operation of the Fig. 6 memory device.

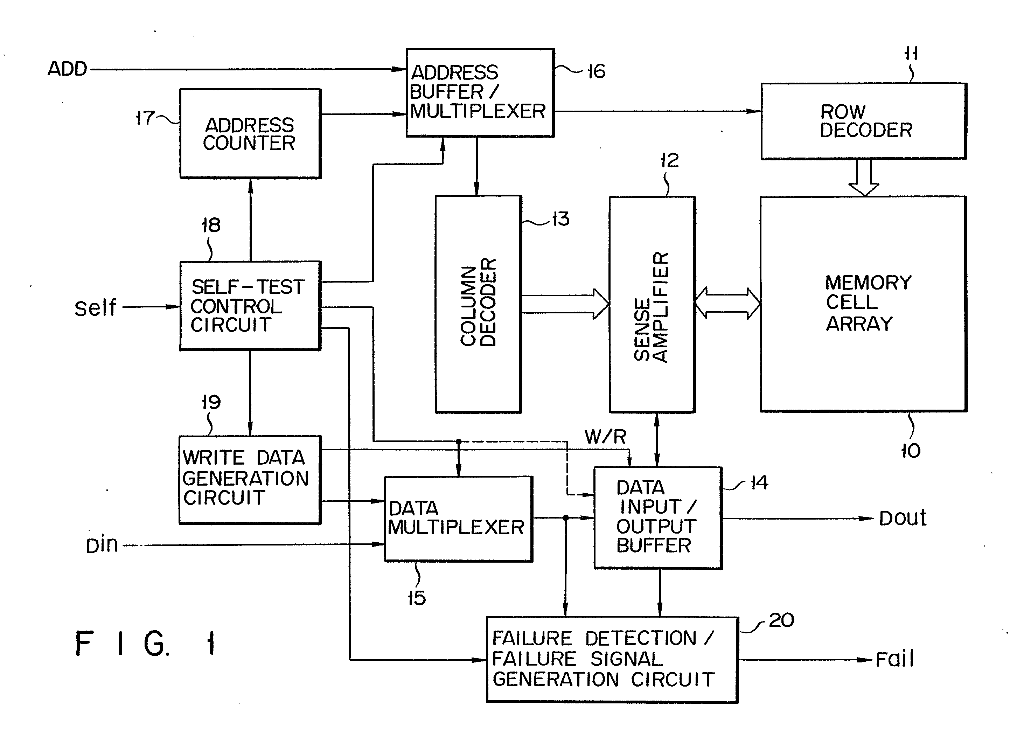

Some specific embodiments of this invention will be described referring the accompanying drawings. Fig. 1 shows in block form a dynamic random access memory (DRAM) of the type in which one word consists of one bit. A semiconductor memory device according to this invention is incorporated into this DRAM.

In the figure, reference numeral 10 designates a memory cell array including a plurality of dynamic memory calls (not shown) arrayed in a matrix fashion. Memory cells (not shown) of n (n: the number of memory cells) on one row line in memory cell array 10 are simultaneously read out by the output signal from row decoder 11. The data read out of these cells are supplied to sense amplifier 12. Sense amplifier 12 is provided with sense amplifiers (not shown) of n, whose number corresponds to the number of memory cells laid on one row. One of the n data output from these sense amplifiers is selected by the output signal from column decoder 13. Data input/output buffer 14 is provided. In a read mode of this memory device. data input/output buffer 14 outputs the selected data denoted as Dout. In a write mode, that buffer 14 receives the data from data multiplexer 15 to be given later, and transfers it to the corresponding sense amplifier in sense amplifier 12. Also in this mode, the data from the sense amplifier is written into the selected memory cell in memory array 10.

To be more specific, one of those memory cells in memory array 10 is selected by the output signals from row and column decoders 11 and 13. Data is written into and read out of the selected memory cells. via data input/output buffer 14.

Row and column decoders 11 and 13 are supplied with an address signal output from address buffer/multiplexer 16. This circuit 16 separately receives an external address signal ADD and an internal address signal. The external address signal ADD includes row and column address signals each consisting of a plurality of bits. These row and column address signals are supplied via external terminals (not shown) in a time divisional manner. to address buffer/multiplexer 16. The internal address signal is generated from address counter 17. Address buffer/multiplexer 16 selects one of the external and internal address signals, according to the control signal from self-test control circuit 18 to be given later, and generates a signal, which is complementary in level to the selected address signal. The complementary signal is supplied to row decoder 11 and column decoder 13.

Data multiplexer 15 is coupled with external data Din transferred via an external terminal (not shown), and internal data for self-test generated by write data generation circuit or write data generator 19. Data multiplexer 15 selects one of the internal data Din and the external data Dout. according to the control signal from self-test control circuit 18, and supplies the selected data to data input output buffer 14.

In self-test mode. address counter 17 sequentially generates the internal address signals containing the internal row and column address signals. according to the control signal from self-test control circuit 18. In the self-test mode. write data generation circuit 19 is controlled by the control signal from self-test control circuit 18, to sequentially generate the internal data to be written into memory cell array 10. At the same time, the generation circuit generates a signal W/R for setting up the write and read modes, which is supplied to data input/output buffer 14.

Reference numeral 20 designates failure detection failure signal generation circuit. In the self-test diagnosis mode. this circuit 20 receives the data read out from memory array 10 via data input output buffer 14. and the internal data from write data generation circuit 19. which is output from data multiplexer 15. Following this, failure detection failure signal generation circuit 20 compares both the data. When both data are not coincident with each other, the circuit 20 outputs a failure signal "Fail" to indicate that a defective cell exists.

When receiving a self-test start signal "Self" at the external terminal (not shown) specially provided. self-test control circuit 18 starts the self-test operation, and supplies control signals to address counter 17, write data generation circuit 19, address buffer/multiplexer 16, data multiplexer 15 and failure detection/failure signal generation circuit 20, to thereby control these circuits.

The following is a description of the operation for the self-test of the memory device thus arranged.

Upon receipt of self-test start signal "Self", self-test control circuit 18 starts the self-test operation, and supplies control signals to address counter 17, write data generation circuit 19, address buffer/multiplexer 16, data multiplexer 15 and failure detection/failure signal generation circuit 20. In response to the control signal, address counter 17 generates the internal addresses containing the row and column address signals, which are used for selecting all of the memory cells in memory cell array 10 in a sequential manner. At the same time, write data generation circuit 19 continuously generates "0" level data in the first cycle.

When receiving the control signal from self-test circuit 18, address buffer/multiplexer 16 selects the internal address signal generated by address counter 17, and transfers it to row and column decoders 11 and 13. Data multiplexer 15 selects the internal data generated by write data generation circuit 19, and transfers the selected one to data input/output buffer 14. In the first cycle, data input/output buffer 14 is set in the write mode, by the mode setting signal W/R derived from write data generation circuit 19. In this mode, "0" level data is written into the memory cells successively selected by row and column decoders 11 and 13.

In the read-out cycle following the completion of writing "0" level data into all of the memory cells in memory array 10, data input/output buffer 14 is set up in the data read-out mode by a mode setting signal W/R derived from write data generator 19. Address counter 17 starts to sequentially generate the internal address signals each consisting of the row address signal and the column address signal, which are for selecting a memory cell in memory cell array 10. During this cycle, failure detection failure signal generation circuit 20 sequentially detects the coincidence or noncoincidence between the data, which are sequentially read out from each memory cell via data input/output buffer 14, and the "0" level data from write data generator 19. The circuit 20 does not output a failure signal "Fail" when the data from memory cell and the data from write data generator 19 are coincident. When these data are not coincident, the circuit 20 outputs a failure signal "Fail", when, for example, the test of all of the memory cells loaded with the "0" level signal has been completed.

In the next write cycle, write data generator 19 continuously generates "1" level data. The "1" level data are written into all of the memory cells in successive manner, as in the previous case. In the succeeding cycle where the "1" level data have been written into all of the memory cells, as in the case of the "0" level data, the data stored in the memory cells are successively read out (read cycle) at a predetermined timing, e.g., when the memory cells storing the "1" level data have all been tested, and subjected to the failure test by the circuit 20. If a failure is detected, a failure signal "Fail" is produced.

As well known, in a system containing the semiconductor memories such as MOS dynamic RAMs and static RAMs, most of defective memory cells, which are found in the field use of the system, is caused by deterioration of the cell oxide film or disconnection of wiring. It is a rare case that the transistor characteristics gradually deteriorate with time, and the transistors eventually fail to satisfy the specifications for the RAM. For this reason, the failure check of the memory in the field use does not require such a complicated test as in the stage of chip selection. Thus, as in the above-mentioned embodiment, such a simple test suffices as to merely check if "0" or "1" level data can be properly written into and read out of all of the memory cells.

In constructing a system using a plurality of memories according to this invention, all of the memories, i.e., RAMs can be self-tested by applying the self-test start signal to all of the memories, i.e., RAMs simultaneously. Therefore, the test time can be remarkably reduced when comparing with the conventional test in which the memories are serially tested one by one. The test time of the Fig. 1 embodiment is reduced to 1/N (N: the number of memories) when comparing with the conventional test. An additional advantage of the failure test according to this invention is that a very short time must be waited for before the start check required when the system containing the memory devices according to this invention is started up. Thus, the working efficiency of failure check is considerably improved, and frequent checks are possible securing a high reliability in the operation of the resultant memory device.

The read and write operations of the external data ADD are the same as those of the conventional memory device, and hence no further explanation will be given.

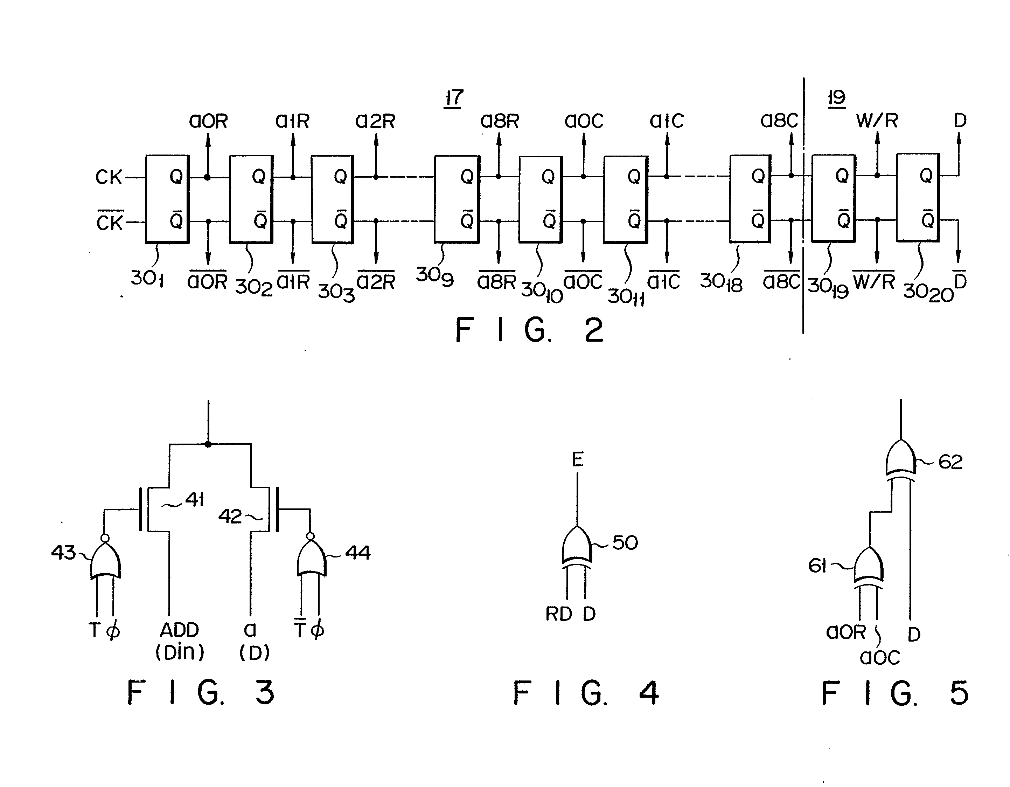

Figs. 2 to 4 show the configurations of some key circuits used in the above-mentioned embodiment.

Fig. 2 is a schematic illustration of address counter 17 and write data generator 19. In the illustration, counters $31_1$ to $31_z$ each composed of R-S flip-flop are serially connected so that the Q and $\overline{Q}$ output signals of the flip-flop at a preceding stage are coupled with the inputs of the flip-flop at a succeeding state, respectively. These counters may be frequency dividers. As shown, counters $30_1$ to $30_{18}$ make up the address counter 17, and counters $30_{19}$ to $30_z$ the write data generator 19. The output signal of the counter of address counter 17, which provides the most significant digit, is supplied to the write data generator 19. The input signals to the first stage of counter $30_1$ are the clock signals CK and $\overline{CK}$ which are generated during the self-check operation. Each of counters $30_1$ to $30_z$ divides by 2 the frequency of input clock signals CK and $\overline{CK}$. The output signals of 9 bits from the first to ninth counters $30_1$ to $30_9$ are supplied to address buffer/multiplexer 16, as the row address signals a0R and $\overline{a0R}$ to a8R and $\overline{a8R}$ of the internal address signal. The 9 bits output signals from the tenth to eighteenth counters $30_{1C}$ to $30_{18}$ are supplied to address buffer/multiplexer 16, as column address signals a0C and $\overline{a0C}$ to a8c and $\overline{a8C}$ of the internal address signal. The output signal from counter $30_{19}$ is used as a write/read signal W/R for setting up a data write mode and a read write mode. The output signal of counter $30_x$ is supplied as the internal data to data multiplexer 15. The number of counters forming address counter 17 is not limited to 8. and is determined by the capacity of the memory.

With such an arrangement, before self-test control circuit 18 starts the self-check operation, the Q output signal of each flip-flop is "0" level, and the $\bar{Q}$ output signal is "1" in level. Therefore, the internal row and column address signals of 9 bits are in "0" level, and the write/read signal W/R is also in "0" level. The data input/output buffer 14 is placed in the data write mode, and the internal data D is in the "0" level. Under this condition, if self-test control circuit 18 starts the self-test operation. and generates a pair of clock signals CK and $\overline{CK}$. all of the bits of the internal column address signal are left in the "0" level. and the internal row address signal of address counter 17 is changed. The internal address signal is supplied to row decoder 11 and column decoder 13. via address buffer multiplexer 16. As a result; the memory cells connected to the column selected by the column address signal whose all bits are in the "0" level are successively selected one by one. by the internal row address signal, and the data are written into the selected memory cells in successive way. At this time, the data D to be stored in each memory cell is the "0" level data. When all of the Q outputs of the counter $30_1$ to $30_5$ are logical "1", the data writing to all of the memory cells on the column whose column addresses are all "0", is completed. Then, the Q output signal of counter $30_6$ changes its logical level from "0" to "1", and the next column is specified. The internal row address successfully changes its value from the initial value so that "0" level data are written into the memory cells connected to the column. When the signal change of the internal row and column address signals is completed in one cycle, the Q output of counter $30_9$ is changed to logical "1", that is. the write/read signal W/R is changed to logical "1", and data input/output buffer 14 is placed in the data readout mode. Also in this mode, self-test control circuit 18 generates a pair of clock signals CK and $\overline{CK}$. Therefore, as in the data write mode, the internal row address is progressively changed. When the internal address signal is supplied to row and column decoders 11 and 13, the memory cells of memory cell array 10 into which the "0" level data have been stored are successively selected, and the data are read out of the selected memory cells in the same manner. The read out data are supplied to failure detection/failure signal generation circuit 20 via data input/output buffer 14. At this time, the internal data generated by counter $30_x$ still remains "0" level, and the internal data is being supplied to failure detection/failure signal generation circuit 20. The circuit detects if both the data are coincident or not. If not coincident. then the circuit 20 produces a failure signal "Fail" at a predetermined timing, when, for example, the test of all of the memory cells into which the "0" level data have been stored, is completed.

In this data read out mode. if the change of the row and column address signals is completed, the write/read signal W/R is changed to logical "0", and the internal data D output from counter $30_x$ is changed from logical level "0" to logical level "1". As a result, data input/output buffer 14 is set in the write mode again, and the internal data to be written into the selected memory cells is logical "1". As in the case of writing "0" level data into the memory cells. all of the memory cells of the memory cell array 10 are successively selected and the logical "1" data is written into the selected memory cells. After completion of one cycle of change of the row and column address signals, the write read signal W/R is changed to logical "1". As in the case of the "0" level data, failure detection/failure signal generation circuit 20 checks if the data written into each memory cell is coincident with that output from write data generator 19. If not coincident. the circuit 20 generates a failure signal "Fail".

By performing the four cycles of the change of row and column address signal in this way, "1" level data is written into all of the memory cells in the memory cell array 10 and the written data is read out, and "0" level data is written into all the memory cells and the written data is read out. In the read mode, the detection of the defective cell is performed.

The usual dynamic RAM is provided with a refresh counter for refreshing the memory cells. The refresh counter selects the memory cells of memory cell array 10 row by row. To refresh the memory cells. data for the memory cells of one row are supplied to the sense amplifiers 12 in parallel. Therefore, it is only needed for the refresh counter to generate only the row address signals. In this invention, the part of address counter 17, i.e., counters $30_1$ to $30_9$, in place of a specially provided refresh counter, are used for refreshing the memory cells data.

Fig. 3 shows a detailed circuit of a one-bit multiplexer of address buffer/multiplexer 16. The description of the one-bit address multiplexer can also be applied for the one-bit data multiplexer. In the description, parenthesized words will refer to the data multiplexer. As shown in Fig. 3, the multiplexer is composed of a pair of MOS transistor switches 41 and 42, and a pair of NOR gates 43 and 44. MOS transistor switch 41 is coupled at one end with one-bit external address ADD (external data Din). MOS transistor switch 42 is coupled at one end with one-bit internal address "a" from address counter 17 (the internal data D from write data generator 19), and at the other end with the other end of switch 41. NOR gate 43 receives a clock signal φ in synchronism with the clock signal from self-test control circuit 18, and a signal T generated by self-test control circuit 18, for indicating if the self-test is in progressing. NOR gate 44 receives clock signal φ and signal $\overline{T}$, which is an inversion of signal T. The output signal from NOR gate 43 is supplied to the gate of MOS transistor switch 41, while the output signal of NOR gate 44 is supplied to the gate of MOS transistor switch 42. In this circuit, signal T is logical "1" and signal $\overline{T}$ is 'logical "0" in the self-test mode. The output signal of NOR gate 43 remains logical "0" independent of clock signal φ and MOS transistor switch 41 is left closed. The output signal of NOR gate 44 is set to logical "1" every time clock signal φ is changed to logical "0". In synchronism with this, MOS transistor switch 42 is opened. In the self-test mode in which signal $\overline{T}$ is logical "0", address buffer/multiplexer 16 selects internal address "a" (internal data D). In the normal mode in which signal T is logical "0", that is to say, during the period that external data Din is written or the data is read out as Dout, multiplexer 16 selects external address ADD (external data Din).

Fig. 4 shows a detailed circuit of the failure testing portion of failure detection/failure signal generator 20. As shown in the figure, this circuit comprises an exclusive OR gate 50 which receives the data RD read out of the memory cells, and the data D from write data generator 19. When both data are in the same logical level, OR gate 50 produces a logical "0" signal as output signal E. When in different logical levels, it produces a logical "1" signal as a failure signal "Fail". If the gate output E is logical "1" even at one time, failure signal "Fail" indicating that a defective cell is contained in the memory cell array 10 is produced, when, for example, all of the cells are detected.

As seen from the foregoing, the memory device of the above-mentioned embodiment can obtain many advantages with only a few additional circuits. Therefore, the circuit designing is not so complicated, and the chip area required for the additional circuit is not so increased.

It should be understood that this invention is not limited to the above-mentioned embodiment, but may variously be changed and modified within the scope of this invention. In the embodiment, predetermined data is written into all of the memory cells in memory cell array 10, in the self-test mode. Then, the written data is read out of all of the memory cells. Alternatively the data is written into a single memory cell. Then, it is read out of that cell for check. The read and write operations are repeated every cell. Specifically, a "0" data is written into the memory cell, and the written data is read out of the cell for check. These operations are sequentially applied for all of the memory cells. Then, a "1" data is subjected to the similar operations. In another modification, a "0" data is written into a memory cell, and that data is read out of it for check. The memory cell is subjected to the same operations for a "1" data. A sequence of these operations is repeated for each memory cell until such sequence of operations for all of the memory cells are completed.

In the above-mentioned embodiment, write data generator 19 continuously generates "0" and "1" data. Alternatively, this circuit may generate the data of a checker board pattern of bits in which the "0" and "1" data alternately appear.

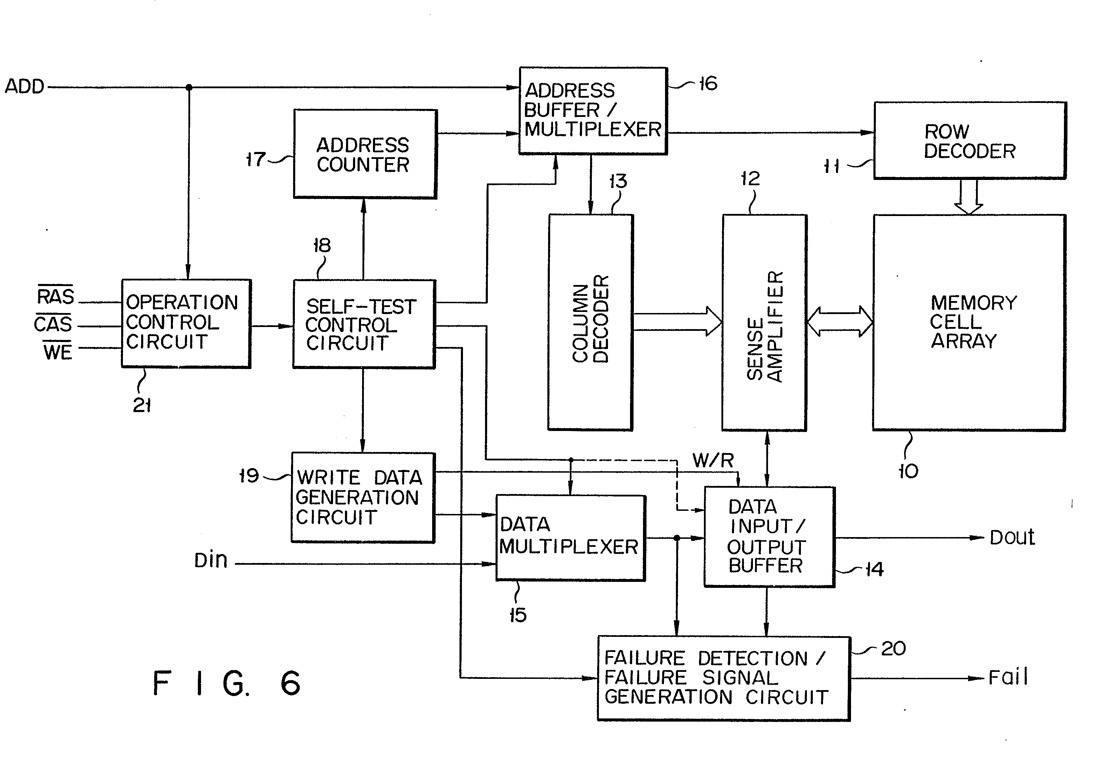

To generate the checker board pattern, a circuit as shown in Fig. 5 is added to write data generator 19 shown in Fig. 2. This circuit is comprised of exclusive OR gates 61 and 62. OR gate 61 receives the least significant bit a0C of the internal column address signal, which is generated by the address counter 17 shown in Fig. 2, and the least significant bit a0R of the internal row address signal generated by address counter 17. OR gate 62 receives the output signal of OR gate 61, and the data D generated by the final stage counter $30_x$ of the address counter 17 shown in Fig. 2.

In the initial stage of the operation of this additional circuit, the data D from counter $30_x$ is logical "0", and the column row address signals a0C and a0R are also both logical "0". Therefore, the data output from gate 62 is logical "0". When internal row address signal a0R is changed to logical "1", the output data from gate 61 goes high (logical "1"), and the output data from gate 62 also goes high. Subsequently, the internal row address signal a0R is alternately inverted every time the clock signal CK is applied to address counter 17, so that the output data of gate 62 is also alternately inverted. When one cycle of the changes of the internal row address signals is completed, the change of the row address signal starts again. At this time, the least significant bit a0C of the internal column address signal has been inverted to the "1" signal. Accordingly, the data output from the gate 62 is logical "1". When the internal row address signal a0R is logical "1", the output data of gate 62 is inverted to the logical "0". Subsequently, the internal row address signal a0R is alternately inverted every time the clock signal CK supplied to address counter 17, and output data of gate 62 is also alternately inverted. Data stored in the memory cells connected to the column selected when the internal column address signal a0C is logical "0", and data stored in the memory cells connected to the column selected when the signal a0C is logical "1" are interchanged with each other. In the read mode, the data as written in the checker board pattern is output from the failure detection failure signal generation circuit 20 as in the write mode. This circuit checks if both data are coincident with each other or not. Through this check, the self-check of the written data is performed.

In the above-mentioned embodiment, failure signal "Fail" is output when all of the memory cells are checked. Alternatively, it may be output when a noncoincidence of the data is detected.

The self-check operation may be stopped, when a noncoincidence of the data was detected.

In the embodiment as mentioned above, the data to be written into the memory cells in the self-test mode is generated by write data generator 19, which is incorporated in the memory device. This data may be the data Din supplied from exterior. The control signal supplied to self-test control circuit 18 may be set at such a potential that it is not used in the normal mode. The control signal may be supplied to the external terminal used in the normal mode. In the embodiment, the address signal to designate the memory cell in the self-test mode is generated by the address counter 17 in the memory device. This signal may be the address signal ADD supplied from exterior. In this way, by using the external address signal, the defective memory cell can be detected quickly.

The dynamic RAM used in the embodiment has a one-bit configuration, but it may be a 4 bits or 8 bits configuration, if necessary. A static RAM may be used in place of the dynamic RAM. The operation cycle when the self-test is performed may be controlled by the signal of RAS (row address strobe), CAS (column address strobe) or CE (chip enable). Additionally, the cycle may be controlled by making use of e self-oscillation function of a timer, which is formed on the clip.

Fig. 6 shows a semiconductor memory according to another embodiment of this invention. This circuit is equal to that of Fig. 1, except an operation control circuit is used.

Self-test control circuit 18 is operated by operation control circuit 21.

Column address strobe $\overline{CAS}$ used in the normal operation, row address strobe signal $\overline{RAS}$, write enable signal $\overline{WE}$, and external address ADD are supplied to the external terminals of operation control circuit 21. When the order of inputting of these signals and levels of them meet predetermined conditions, an operation signal is output to self-test control circuit 18.

The operation of the memory device will be described. The read and write operations of the RAM are performed under control of control signals $\overline{RAS}$, $\overline{CAS}$ and $\overline{WE}$.

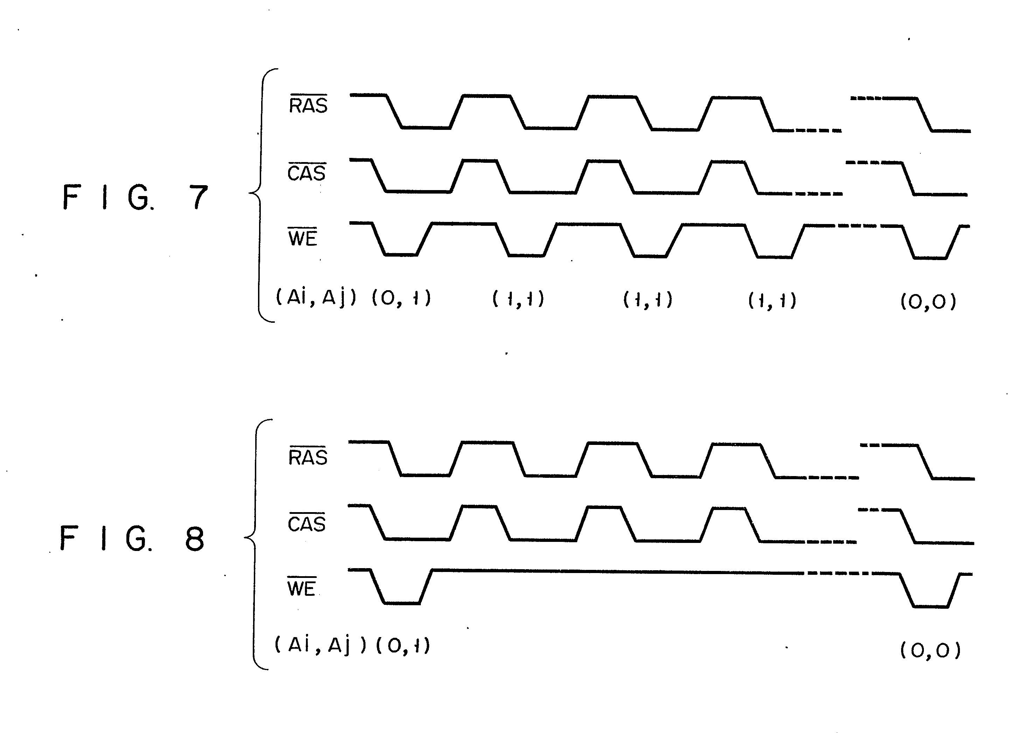

To execute the self-test, these controls signals and the external address signal ADD are input under predetermined conditions. For example, as shown in Fig. 7, in the normal operation mode, the signal $\overline{CAS}$ is set to logical "0", and then the signal $\overline{RAS}$ to logical "0". When the signal $\overline{RAS}$ is logical "0", the signal $\overline{WE}$ is set to "0". When these signals are both logical "0", if predetermined two bits (Ai, Aj) of the external address signal ADD are set to (0, 1), the operation control circuit 21 produces an operation signal for self-test operation.

Upon receipt of this operation signal, self-test control circuit 18 outputs control signals to the selected circuits. The subsequent operation is the same as that in the Fig. 1 embodiment.

In the self-test mode, the external address (Ai, Aj) are set to (1, 1).

When the detection of all the memory cells are completed, as seen in Fig. 7, after signal $\overline{CAS}$ is dropped to the "0" level, signal $\overline{RAS}$ is dropped to the "0" level. Under this condition, when the signals $\overline{RAS}$ and $\overline{WE}$ are both logical "0", the external address signal (Ai, Aj) are set to (0, 0). At this time, operation control circuit 21 detects the end of the self-check to stop the operation of self-test control circuit 18.

In a system using a plurality of memory devices shown in Fig. 6, if the signals $\overline{RAS}$, $\overline{CAS}$ and $\overline{WE}$ are input in parallel to all of the semiconductor memory devices, all of the memory devices can perform the self-test operation concurrently. The time required for the self-test operation of the system under discussion is remarkably reduced when comparing with the self-test operation by the conventional memory of the type in which the self test is serially performed every memory device. The test time of the Fig. 6 embodiment is reduced to 1/N (N: the number of memories) when comparing with the conventional circuit.

The input conditions for each signal for detecting the start and end of the self-test operation by operation control circuit 21 are not necessarily defined by the timing charts of Fig. 7. An alternative example is shown in Fig. 8. As shown in the figure, write enable signal $\overline{WE}$ is set to logical "0" only when the self-test operation starts and ends. When write enable signal $\overline{WE}$ is in logical "0", the external address signal (Ai, Aj) is set to (0, 1) or (1, 1).

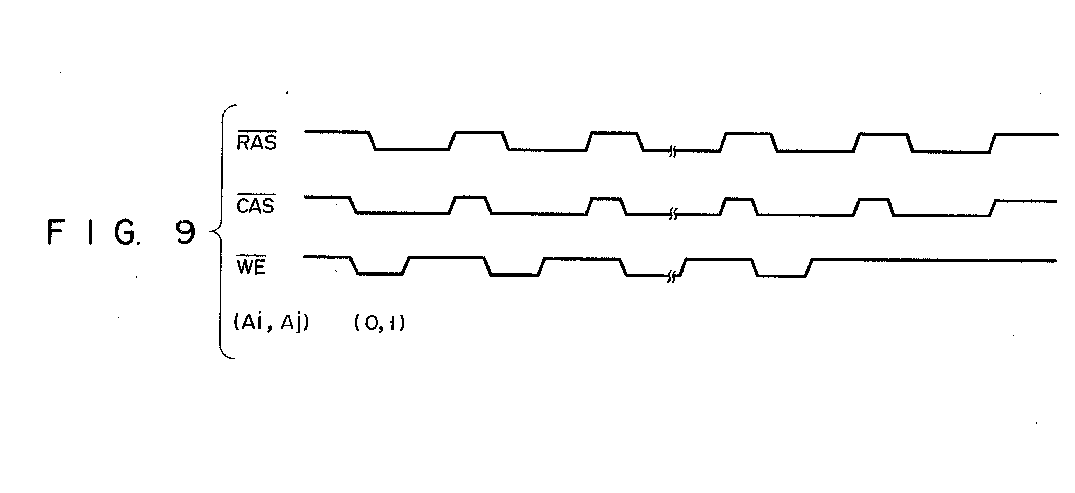

A further example is shown in Fig. 9. As shown in the figure, the signal $\overline{CAS}$ is set to logical "0", and then the signal $\overline{RAS}$ is logical "0". When the $\overline{RAS}$ is logical "0", the signal $\overline{WE}$

is set to logical "0". When these signals are both logical "0", bits (Ai, Aj) of the external address signal ADD are set to logical (0, 1). The number of bits of the address signals are not limited to two. and is determined by the capacity of the memory.

The Fig.6 embodiment can attain the beneficial effects comparable with those of the Fig. 1 embodiment.

In the embodiments of Fig. 1 and Fig. 6, the fail signal terminal and Dout signal terminal are separated. However, a single terminal may be used for the fail signal and the Dout signal. In such a case, the control signal supplied to data multiplexer 15 from self-test control circuit 18 is also input to data input/output buffer 14, as shown by a dotted line. Buffer 14 and failure detection/failure signal generation circuit 20 are controlled by the control signals from self-test control circuit 18, so that data supplied from write data generation circuit 19 and data read out of memory cell array 10 are selectively output. When the data are coincident, buffer 14 issues output signal Dout. When the data are not coincident, circuit 20 issues fail signal "Fail".

As seen from the foregoing description, the semiconductor memory devices according to this invention, if assembled into a system, can concurrently be checked as to if defective memory cells are contained in the memories.

This feature can remarkably reduce the check time when the system starts to operate, resulting in the quickened start-up of the system.

## Claims

1. A semiconductor memory device comprising:

a memory cell array (10) including a plurality of memory cells;

memory cells select means (11, 13, 16) for selecting a memory cell in said memory cell array (10); and

data write means (14) for writing data into the memory cell selected by said memory cell select means;

data read out means (12, 14) for reading out the data from the memory cell selected by said memory cell select means; characterized by further comprising:

self-test means (17, 18, 19, 20) for operating said data write and read means in responsive to a control signal, writing predetermined data into the memory cells in said memory cell array (10), reading out the data from said memory cells, and checking if an error is contained in the read out data.

2. The semiconductor memory device according to claim 1, characterized in that said self-test means (17, 18, 19, 20) includes an address counter (17) for generating an address signal to specify any of the memory cells in said memory cell array, a write data generation circuit (19) for generating the data to be written into said memory cells, a data comparing circuit (20) for comparing the same data as that stored into said memory cells with the data read out of said memory cells, and a control circuit (18) for operating said address counter, said write data generation circuit, and said data comparing circuit in response to said control signal, and for controlling the operation of said circuits.

3. The semiconductor memory device according to claim 2, characterized in that said address counter (17) and said write data generation circuit (19) are comprised of a plurality of counters coupled in series, and said write data generation circuit is coupled with the output signal from that counter of said counters forming said address counter. which provides the most significant bit.

4. The semiconductor memory device according to claim 2, characterized in that the memory cells in said memory cell array (10) are dynamic cells, and some of the counters forming said address counter generate an address signal used for refreshing the memory cells.

5. The semiconductor memory device according to claim 1, characterized in that said control signal is supplied from an external terminal specially provided, which is not used in the normal operation.

6. The semiconductor memory device according to claim 1, characterized in that said control signal has a potential which is supplied to an external terminal used in the normal operation, and is different from those used in the normal operation.

7. The semiconductor memory device according to claim 1, characterized in that said self-test means (17, 18, 19, 20) is provided with a failure signal output means (20) for outputting a signal indicative of detection of error data.

8. The semiconductor memory device according to claim 1, characterized in that the checking cycle of said self-test means (17, 18, 19, 20) is controlled by timer means.

9. The semiconductor memory device according to claim 1, characterized in that said address counter (17) includes a plurality of R-S flip-flop ($30_1$ to $30_{18}$) serially connected.

10. The semiconductor memory device according to claim 1, characterized in that said address counter (17) includes a plurality of frequency divider ($30_1$ to $30_{18}$) serially connected.

11. The semiconductor memory device according to claim 1, characterized by further comprising operation control means (21) for detecting that predetermined signals are input to a plurality of external terminals used in the normal operation in a predetermined order and predetermined levels, and for providing said control signal for operating said self-test means.

12. The semiconductor memory device according to claim 11, characterized in that the predetermined signal detected by said operation control means (21) contains some or all of the address signals.

13. The semiconductor memory device according to claim 11, characterized in that some lower order digits of said address counter (17) are used as a row address to address said memory cells. and some higher order digits are used as a column address to address said memory cells.

14. The semiconductor memory device according to claim 11. characterized in that said operation control means (21) detects a column address strobe signal ( $\overline{CAS}$) and a row address strobe signal ( $\overline{RAS}$). which are input via said plural external terminals. and operates said self-test means when detecting that the column address strobe signal is input prior to the row address strobe signal.

15. The semiconductor memory device according to claim 11, characterized in that said operation control means (21) detects a column address strobe signal ( $\overline{CAS}$). a row address strobe signal ( $\overline{RAS}$), and a write enable signal ( $\overline{WE}$), which are input via said plural external terminals, and operates said self-test means in response to the level of the write enable signal when detecting that the column address strobe signal is input prior to the row address strobe signal.

16. The semiconductor memory device according to claim 11, characterized in that said operation control means (21) detects a column address strobe signal ( $\overline{CAS}$). a row address strobe signal ( $\overline{RAS}$), a write enable signal ( $\overline{WE}$), and an external address signal, which are input via said plural external terminals, and operates said self-test means when detecting that the column address strobe signal is input prior to the row address strobe signal, and the write enable signal is in a predetermined level, and the bits of the external address signal have predetermined levels.

F I G. 1

0 263 312

FIG. 2

FIG. 3

FIG. 4

FIG. 5

F I G. 6

0 263 312

F I G. 7

$\overline{RAS}$

$\overline{CAS}$

$\overline{WE}$

(Ai, Aj)  (0, 1)        ( 1, 1)        ( 1, 1)        ( 1, 1)        (0,0)

F I G. 8

$\overline{RAS}$

$\overline{CAS}$

$\overline{WE}$

( Ai , Aj ) ( 0, 1)                                        (0,0)

F I G. 9

RAS

CAS

WE

(Ai , Aj)        (0, 1)

0 263 312